# EUROPEAN PATENT APPLICATION

(11) **EP 0 962 970 A2**
(43) Date of publication of application: **08.12.1999**
(21) Application number: 99110511.5
(22) Date of filing: 31.05.1999
(51) Int. Cl.: H01L 21/768, H01L 21/02

(54) **Capacitor element and fabrication method thereof**

(30) Priority: 01.06.1998 JP 15154998
(71) Applicant: NEC CORPORATION, Tokyo (JP)
(72) Inventor: Nishimura, Takeshi B., Minato-ku, Tokyo (JP); Takemura, Koichi, Minato-ku, Tokyo (JP)
(74) Representative: Glawe, Delfs, Moll & Partner

(57) **Abstract**

A lower electrode 12 is formed on a substrate 11 and is covered by an interlayer insulating film 13. Through-holes 21 and 22 are formed in the interlayer insulating film and a dielectric film 14 and an upper electrode 15 are formed in the through-hole 21 and a periphery thereof, in the order, and wiring layers 16 connected respectively to the upper electrode 15 and a portion of the lower electrode 12, which is exposed through the through-hole 22, are formed. As a material of the dielectric film 14, a dielectric material such as STO, which has high dielectric constant, is used. A platinum barrier layer is provided in at least a portion of the upper electrode 15, which is in contact with the dielectric film 14, for restricting a reaction between the upper electrode 15 and the dielectric film 14. An inner wall of the through-hole 21 is inclined with respect to the substrate 11 by an angle of 75 degree or more. A reliable capacitor element, which can be formed at high density and can be easily integrated with other elements, is provided.

## Description

### CROSS REFERENCE TO RELATED APPLICATIONS

The present invention claims priority from Japanese Patent Application No. 10-151549 filed June 1, 1998, the contents of which are incorporated herein by reference.

### BACKGROUND OF THE INVENTION

### 1. Field of the Invention

The present invention relates to a capacitor element formed on a semiconductor substrate.

### 2. Description of Related Art

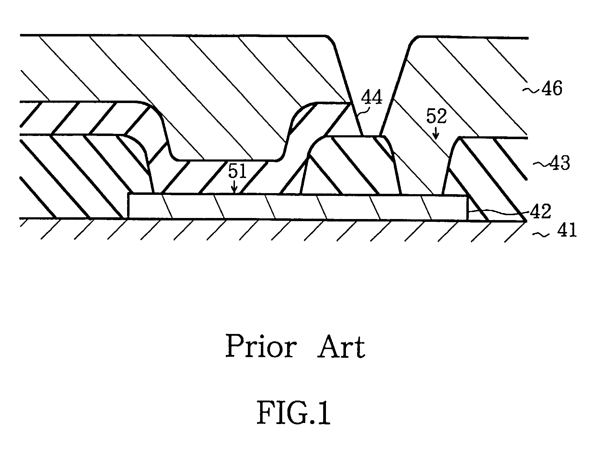

Fig. 1 is a cross section showing a structure of a conventional capacitor element. This capacitor element includes a lower electrode 42 formed on a substrate 41 and an interlayer insulating film 43 covering the lower electrode 42 and having a first and second through-holes 51 and 52. A dielectric film 44 is formed on the interlayer insulating film 43 including the first through-hole 51. Further, wiring layers 46 are connected to the dielectric film 44 and the lower electrode 42 exposed through the second through-hole 52, respectively.

Japanese Patent Application Laid-open No. Hei 6-120425 discloses another conventional capacitor element structure which is constructed by forming a lower electrode on a relatively large area of a substrate, forming a dielectric film and an upper electrode on an area of the lower electrode, which is narrower than the area of the lower electrode, covering them by an interlayer insulating film, forming through-holes in the upper electrode and a portion of the lower electrode, which is not covered by the dielectric film and the upper electrode and forming a wiring layer.

Japanese Patent Application Laid-open No. Hei 6-140568 discloses a further conventional structure in which an upper and lower electrodes are formed of platinum which is stable with respect to a dielectric film and titanium is used as a material of a wiring, in order to obtain a close adhesion to an interlayer insulating film of silicon oxide.

Japanese Patent Application Laid-open No. Hei 8-64767 discloses a lower electrode having a double layer structure.

Japanese Patent Application Laid-open No. Sho 60-4269 discloses a technique in which an interlayer insulating film surrounding a dielectric film is formed and an upper electrode and a wiring layer are formed on the interlayer insulating film.

The techniques disclosed in Japanese Patent Application Laid-open Nos. Hei 6-120425, Hei 6-140568 and Hei 8-64767 are advantageous in that capacitor elements having simple structure and high breakdown voltage are obtained. However, in each of the disclosed techniques, the freedom of fabrication process is small and fabrication steps thereof can not be commonly used to fabricate other elements such as FET's on a same substrate. Therefore, the number of fabrication steps is increased.

The technique disclosed in Japanese Patent Application Laid-open No. Sho 60-4269 is advantageous in not only that it can realize the miniaturization of capacitor element and the accuracy of capacitance value but also that the formation of electrodes of a capacitor element can be performed simultaneously with the formation of a wiring of other element such as FET. However, in this technique, the interlayer insulating film must be formed to a thickness which is substantially the same as a thickness of the dielectric film, after the dielectric film is formed.

Contrary to these prior arts, the freedom of fabrication process of the conventional structure of the capacitor element shown in Fig. 1 is high and a control of the thickness of the interlayer insulating film is easy. However, since it is necessary, in the structure shown in Fig. 1, to form the dielectric film on a step portion, the material of the dielectric film, which can be utilized, is limited to SiN_{x.}. However, since relative dielectric constant of SiNx is low, it is difficult to increase the capacitance. The reason for this is that, since a dielectric film of a dielectric material having high dielectric constant, such as STO (SrTiO₃), is crystalline, its thickness is reduced at an edge of the step portion, resulting in a reduction of breakdown voltage of the capacitor element. Further, when a dielectric film having high dielectric constant is merely used and if the dielectric film contains titanium, it is usual to use a metal containing titanium as a lowest layer of a wiring. Therefore, titanium of the wiring is diffused to the dielectric film, causing the reliability of the capacitor element to be lowered. Further, when other elements such as FET's are integrated with the capacitor element on the same substrate, the elements integrated together with the capacitor element may be contaminated by titanium of the dielectric film.

### SUMMARY OF THE INVENTION

An object of the present invention is to provide a capacitor element which is capable of being integrated with high density and of being integrated with other elements and is highly reliable.

According to a first aspect of the present invention, a capacitor element which includes a lower electrode, a dielectric film and an upper electrode formed on a substrate in the order, is featured by comprising an interlayer insulating film covering the lower electrode and having a first and second through-holes, the dielectric film and the upper electrode being formed in the first through-hole and extending onto the interlayer insulating film, wiring layers connected to the upper electrode and a portion of the lower electrode which is exposed through the second through-hole, respectively, and a barrier layer of platinum provided on at least a portion of the upper electrode, which is in contact with the dielectric film, for restricting a reaction between the upper electrode and the dielectric film. By restricting the reaction between the upper electrode and the dielectric film, it is possible to prevent the reliability of the capacitor element after fabrication from being lowered.

It is preferable to incline an inner wall of the first through-hole by an angle of 75 degree or less with respect to a surface of the substrate. With such inclination of the inner wall of the first through-hole, a reduction of thickness of the dielectric film at an edge of the step portion can be prevented and, so, a reduction of the breakdown voltage can be prevented. Particularly, when the dielectric film is of a dielectric material having a high dielectric constant, such dielectric film is usually formed by using plasma CVD. In such case, the thickness of the dielectric film formed on a step portion tends to be reduced. Therefore, the inclination of the inner wall of the first through-hole is particularly effective.

According to a second aspect of the present invention, a capacitor element which includes a lower electrode, a dielectric film and an upper electrode formed on a substrate in the order, is featured by comprising an interlayer insulating film covering the lower electrode and the dielectric film and having a first through-hole reaching the dielectric film and a second through-hole reaching the lower electrode, the upper electrode being formed in the first through-hole and extending onto the interlayer insulating film, and wiring layers connected to the upper electrode and a portion of the lower electrode which is exposed through the second through-hole, respectively. Since the dielectric film is flat and having no edge portion, the breakdown voltage of the capacitor element is improved. Further, when the dielectric film is formed of a crystalline dielectric material having high dielectric constant, the crystallinity of the dielectric film is improved due to the flatness of the dielectric film. As a result, the relative dielectric constant of the dielectric film becomes large and a large capacitance can be obtained.

According to a third aspect of the present invention, a capacitance element which includes a lower electrode, a dielectric film and an upper electrode formed on a substrate in the order, is featured by comprising a first interlayer insulating film covering the lower electrode and having a first and second through-holes, the dielectric film being formed in the first through-hole and extending onto the first interlayer insulating film, the upper electrode being formed on the dielectric film within the first through-hole, a second interlayer insulating film covering the dielectric film and having a third through-hole and wiring layers connected to the upper electrode and the lower electrode through the third through-hole and the second through-hole formed in the first interlayer insulating film, respectively. Although the dielectric film has an edge portion, there is no reduction of breakdown voltage since the upper electrode is positioned such that it does not influence the edge portion.

In the third aspect of the present invention, it is possible to provide a plurality of upper electrodes for the first through-hole. In such case, a regulation of capacitance becomes easier and an area of the capacitance element is smaller than that in a case where a number of capacitance elements are formed for capacitance regulation.

In the second or third aspect of the present invention, it is preferable to provide a barrier layer of platinum for restricting a reaction between the upper electrode and the dielectric film in at least a portion of the upper electrode, which is in contact with the dielectric film, similarly to the case of the first aspect of the present invention.

In each of the above mentioned aspects, the dielectric film may be formed of a dielectric material containing titanium as one of constituent elements, particularly, SrTiO₃, BaTiO₃, (Baₓ Sr₁₋ₓ)TiO₃, PbTiO₃ or (PbZr)TiO₃. Alternatively, Sr(BiTa)O may be used as a material forming the dielectric film.

Further, the dielectric film is preferably formed in the third through-hole and the periphery thereof. With such definition of the area on which the dielectric film is formed, it is possible to prevent the reaction between the dielectric film and the substrate, particularly, the contamination of the substrate by titanium when the dielectric film contains titanium to thereby prevent other elements such as FET's formed on the same substrate from being degraded.

According to a fourth aspect of the present invention, a method of fabricating the capacitor element according to the first aspect of the present invention is provided, which is featured by comprising the steps of forming a lower electrode on a substrate, covering the lower electrode by an interlayer insulating film, forming a first through-hole in the interlayer insulating film, forming a dielectric film and an upper electrode on the through-hole and a peripheral portion thereof, in the order, forming a second through-hole in the interlayer insulating film and forming wiring connected to the upper electrode and a portion of the lower electrode, which is exposed through the second through-hole, respectively.

It is preferable to remove portions of the capacitor element, which is unnecessary for the capacitor element, after the dielectric film and the upper electrode are formed.

According to a fifth aspect of the present invention, a method of fabricating the capacitor element according to the second aspect of the present invention is provided, which is featured by comprising the steps of forming a lower electrode on a substrate, covering the lower electrode by an interlayer insulating film, forming a first through-hole reaching the dielectric film and a second through-hole reaching the lower electrode in the interlayer insulating film, forming an upper electrode on the first through-hole and a peripheral portion thereof, forming a second through-hole in the interlayer insulating film and forming a wiring layer connected to the upper electrode and a portion of the lower electrode, which is exposed through the second through-hole, respectively.

According to a sixth aspect of the present invention, a method of fabricating the capacitor element according to the third aspect of the present invention is provided, which is featured by comprising the steps of forming a lower electrode on a substrate, covering the lower electrode by a first interlayer insulating film, forming a first through-hole in the first interlayer insulating film, forming a dielectric film on the first through-hole and a peripheral portion thereof, forming an upper electrode on the dielectric film within the first through-hole, forming a second interlayer insulating film covering the upper electrode, forming a second through-hole reaching the lower electrode and a third through-hole reaching the upper electrode in the second interlayer insulating film and forming a wiring layer connected to the lower electrode exposed through the second through-hole and the upper electrode exposed through the third through-hole, respectively.

### BRIEF DESCRIPTION OF THE DRAWINGS

The present invention will be described in more detail with reference to the accompanying drawings, in which:
Fig. 1 is a cross section showing a structure of a conventional capacitor element;
Fig. 2 is a cross section of a capacitor element according to a first embodiment of the present invention;
Fig. 3 is a cross section of a capacitor element according to a second embodiment of the present invention;
Figs. 4A to 4F illustrate a method for fabricating the capacitor element according to the first or second embodiment of the present invention;
Fig. 5 is a graph showing an effect of a platinum barrier layer used in an upper electrode of a capacitor element;
Fig. 6 is a graph showing a relation between an STO thin film and a breakdown voltage;
Fig. 7 is a graph showing a relation between an inclination of an inner wall of a through-hole and a thickness of the STO thin film on an edge portion of the through-hole;
Fig. 8 is a cross section showing a capacitor element according to a third embodiment of the present invention;
Figs. 9A to 9E illustrate a method for fabricating the capacitor element according to the third embodiment of the present invention;
Fig. 10 is a graph showing a variation of breakdown voltage of a dielectric film, depending upon an edge portion of the dielectric film;
Fig. 11 is a cross section of a capacitor element according to a fourth embodiment of the present invention;
Fig. 12 is a cross section of a capacitor element according to a fifth embodiment of the present invention; and
Figs. 13a to 13F illustrate a fabrication method of the fifth embodiment of the present invention;

### DETAILED DESCRIPTION OF THE PREFERRED EMBODIMENTS

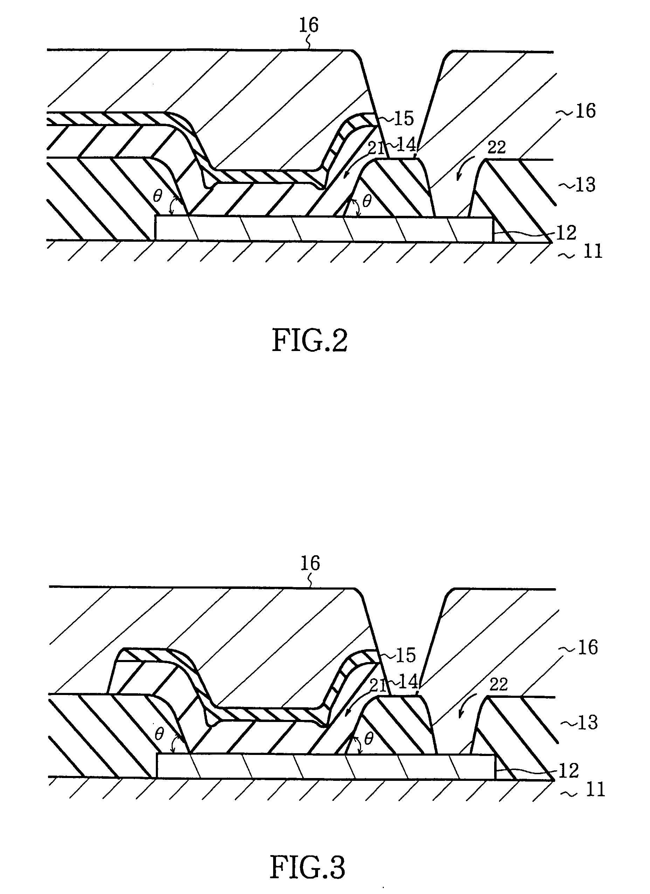

Fig. 2 is a cross section of a capacitor element formed on a substrate, according to a first embodiment of the present invention. In Fig. 2, the capacitor element includes a lower electrode 12, a dielectric film 14 and an upper electrode 15 formed on the substrate 11 in the order. The capacitor element further includes an interlayer insulating film13 formed to cover the lower electrode 12. The interlayer insulating film 13 is formed with a first through-hole 21 and a second through-hole 22. The dielectric film 14 and the upper electrode 15 are formed on the interlayer insulating film 13 and on a portion of the lower electrode 12, which is exposed through the first through-hole 21 and a wiring layer 16 is connected to the upper electrode 15 and to a portion of the lower electrode 12, which is exposed through the send through-hole 22, respectively. The wiring layer 16 is formed of titanium and at least a portion of the upper electrode 15, which is in contact with the dielectric film 14, in this embodiment, a whole portion of the upper electrode 15, is composed of a barrier layer of platinum for restricting a reaction between the dielectric film 14 and the upper electrode 15. An inner wall of the first through-hole 21 is inclined by an angle θ, which is 75 degree or less, with respect to a surface of the substrate 11.

The substrate 11 may be a GaAs substrate having a SiO₂ protective film. The lower electrode 12 may be a double-layer electrode composed of a titanium film 20 nm thick and a platinum film 70 nm thick. The interlayer insulating film 13 may be a SiO₂ film. The dielectric film 14 may be a SrTiO₃ film 300 nm thick. The upper electrode (Pt barrier layer) may be 100 nm and the wiring 16 may be a lamination of a titanium film 20 nm thick, a platinum film 50 nm thick and a gold film 2 µm thick, in the order from the side of the upper electrode 15.

By using the platinum barrier layer as the upper electrode 15, it is possible to restrict the reaction between titanium in the wiring layer 16 and the dielectric film 14 to thereby prevent a degradation of reliability of the capacitor element. Further, by inclining the inner wall of the first through-hole 21 by the angle θ, the coverage of the dielectric film 14 is improved, so that a leak current from the edge of the upper electrode 15 can be prevented.

The dielectric film 14 may be formed of other material than SrTiO₃. For example, BaTiO_{3,} (BaₓSr₁₋ₓ) TiO_{3,} PbTiO_{3,} (PbZr)TiO₃ or Sr(BiTa)O or suitable combinations thereof may be used as the material of the dielectric film 14.

Fig. 3 is a cross section similar to that in Fig. 2, showing a second embodiment of the present invention. The second embodiment differs from the first embodiment in that the dielectric film 14 is formed in the first through-hole 21 and a peripheral portion of the interlayer film insulating 13, which surrounds the first through-hole 21 and the upper electrode 15 is also formed on the dielectric film 14. Since the dielectric film 14 having high dielectric constant is formed on only the first through-hole 21 and the portion of the interlayer insulating film 13 which surrounds the first through-hole 21, a contamination of the substrate 11 can be prevented.

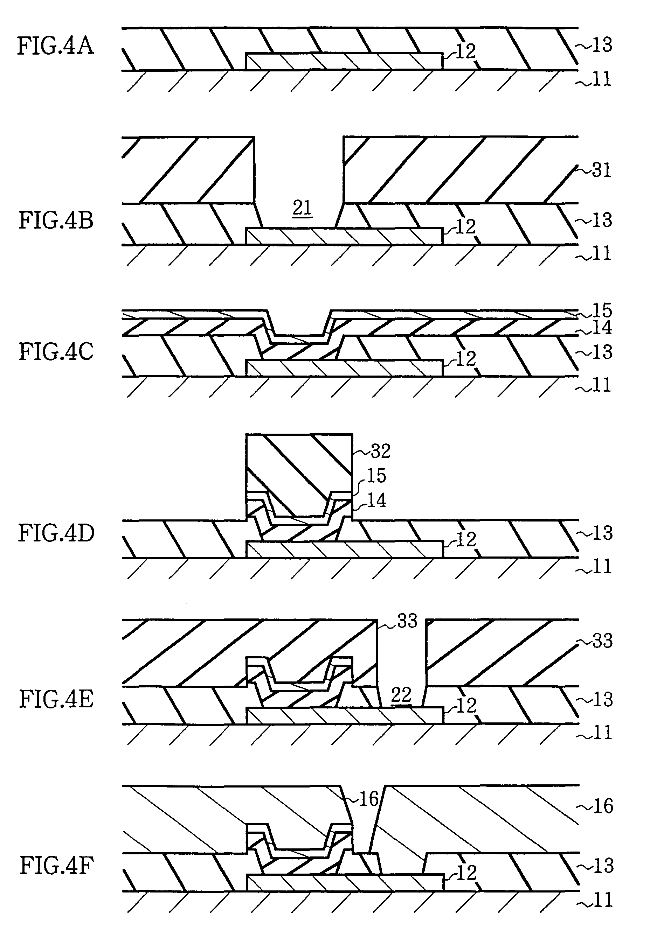

Figs. 4A to 4F are cross sections of a capacitor element according to the second embodiment in Fig. 3, showing respective steps of a fabrication method thereof. First, the lower electrode 12 is vapor-deposited on the substrate 11 by sputtering and, then, the interlayer insulating film 13, as shown in Fig. 4A covers the lower electrode 12. Then, a photo resist mask 31 is formed on the interlayer film 13 and the first through-hole 21 is formed in the interlayer insulating film 13 by etching such that the lower electrode 12 is exposed through the through-hole 21, as shown in Fig. 4B. In this stage, the inner wall of the first through-hole 21 is inclined by the angle θ which is 75 degree or less with respect to the substrate, by forming the first through-hole 21 by dry etching using CF₃ reactive gas. Then, as shown in Fig. 4C, the photo resist mask 31 is removed and the dielectric film 14 and the upper electrode 15 are formed thereon. Then, as shown in Fig. 4D, a photo resist mask 32 is formed in an area including the first through-hole 21 and the dielectric film 14 and the upper electrode 15 are etched away, resulting in the dielectric film 14 and the upper electrode 15 left on only the first through-hole 21 and the portion of the interlayer insulating film 13 which surrounds the first through-hole 21. Thereafter, as shown in Fig. 4E, the second through-hole 22 is formed in another portion of the interlayer insulating film 13 by using a photo resist mask 33. Finally, as shown in Fig. 4F, the wiring layer 16 connected to the upper electrode 15 and the portion of the lower electrode 12, which is exposed through the second through-hole 22, are formed.

In this method, by simultaneously forming the upper electrode 15 and the dielectric film 14, it is possible to remove other dielectric film having high dielectric constant than that necessary for the capacitor element without increasing the number of fabrication steps to thereby prevent the substrate 11 from being contaminated by titanium from the interlayer insulating film 13.

The capacitor element shown in Fig. 2 can be formed similarly except that, in the step shown in Fig. 4D, the photo resist mask 32 is also formed on other area than that of the first through-hole 21 to leave the dielectric film 14 and the upper electrode 15 on other area than that of the capacitor element.

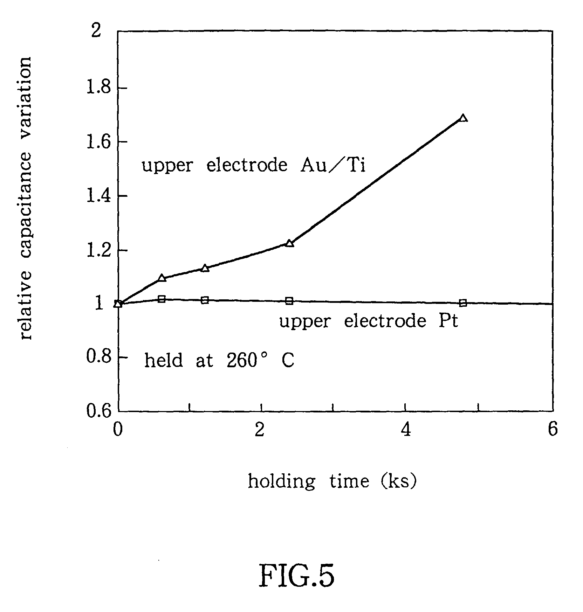

Fig. 5 is a graph showing the effect of the platinum barrier layer in the upper electrode 15. The graph in Fig. 5 shows a relation between a relative capacitance and a holding time of the capacitor elements whose upper electrode 15 has a double layer structure including a gold film 100 nm thick and a titanium film 50 nm thick and whose upper electrode 15 has a single layer structure including a platinum layer 100 nm thick, when these capacitor elements are held at 260° C. As is clear from Fig. 5, the capacitance of the capacitor element varies with time when the upper electrode 15 thereof includes the lowest layer containing titanium, while there is substantially no variation is observed when the upper electrode 15 thereof is formed of platinum.

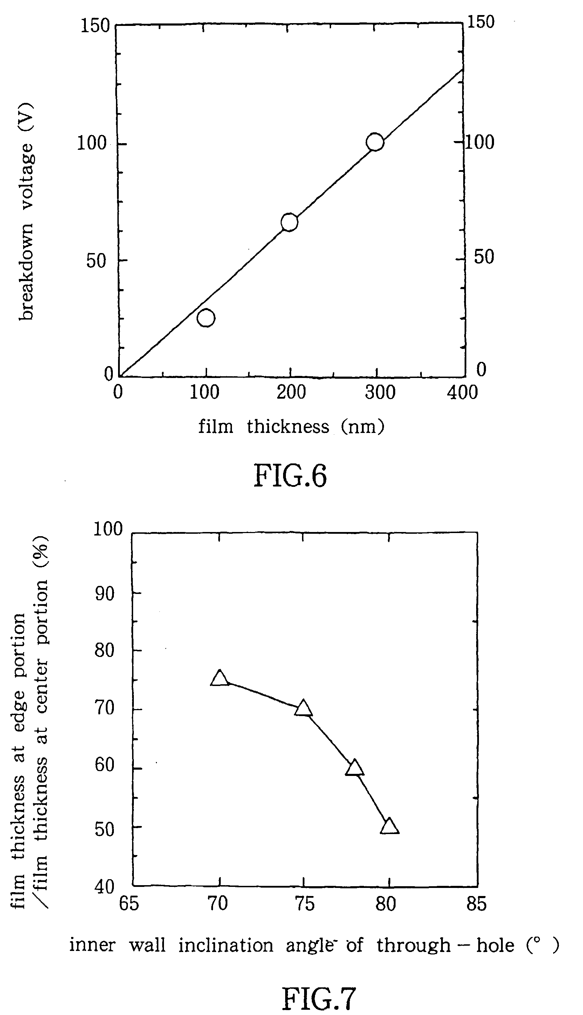

Figs. 6 and 7 are graphs showing the effect of the inclined inner wall of the first through-hole 21, in which Fig. 6 shows a relation between the thickness of the STO thin film and the breakdown voltage and Fig. 7 shows a relation between the inclination angle of the inner wall of the first through-hole 21 and the thickness of the STO film on the edge portion. In a case where an STO film 300 nm thick is formed on the through-hole having the inner wall inclined by, for example, 75 degree, the thickness of the STO film on the edge portion becomes 210 nm and the breakdown voltage of the capacitor element which is determined by this portion becomes 65V. When the inclination angle of the inner wall of the through-hole is increased, the thickness of the edge portion is sharply reduced and the breakdown voltage is reduced correspondingly. Thus, it is possible to prevent the reduction of thickness at the edge portion to thereby prevent the reduction of breakdown voltage, by setting the inclination angle θ of the inner wall of the through-hole 21 to 75 degree or less.

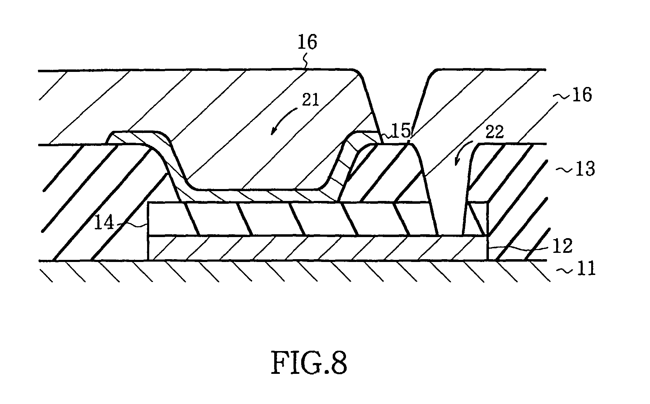

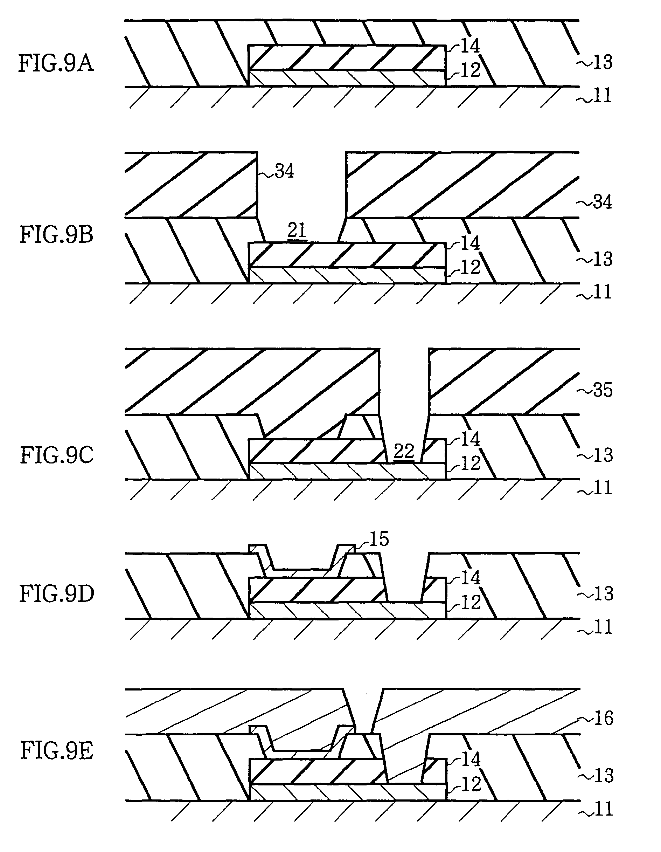

Figs. 8 and 9A to 9E show a third embodiment of the present invention, in which Fig. 8 is a cross section of a capacitor element formed on a substrate and Figs. 9A to 9E show a fabrication steps of the capacitor element shown in Fig. 8.

This capacitor element comprises a lower electrode 12, a dielectric film 13 and an upper electrode 15 formed on a substrate 11 in the order. Further, an interlayer insulating film 13 covering the lower electrode 12 and the dielectric film 14 is provided. A first through-hole 21 reaching the dielectric film 14 and a second through-hole 22 reaching the lower electrode 12 are formed in the interlayer film 13. The upper electrode 15 is formed on the first through-hole 21 and on a portion of the dielectric film 14, which is exposed through the first through-hole 21 and wiring layers 16 are connected to the upper electrode 15 and to a portion of the lower electrode 12, which is exposed through the second through-hole 22, respectively.

The substrate 11 is a GaAs substrate having a SiO₂ protective film, the lower electrode 12 has a double layer structure Pt(70nm)/Ti(20nm) 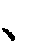 the interlayer insulating film 13 is a SiO₂ film, the dielectric film 14 is a SrTiO₃ film 300 nm thick and the upper electrode 15 is a platinum film 100 nm thick.

Since, in this structure, the dielectric film 14 is flat and has no portion whose thickness is reduced, the breakdown voltage is improved.

In order to fabricate this capacitor element, the lower electrode 12 and the dielectric film 14 are formed on the substrate 11 and covered by the interlayer insulating film 13 as shown in Fig. 9A. Then, as shown in Fig. 9B, a photo resist mask 34 is formed to form the first through-hole 21 reaching the dielectric film 14 in the interlayer insulating film 13. Then, as shown in Fig. 9C, a photo resist mask 35 is formed to form the second through-hole 22 reaching the lower electrode 12. Thereafter, as shown in Fig. 9D, the upper electrode 15 is formed on the first through-hole 21 and the area surrounding the latter and, then, as shown in Fig. 9E, the wiring layer 16 connected to the upper electrode 15 and the portion of the lower electrode 12, which is exposed through the second through-hole 22, respectively, is formed.

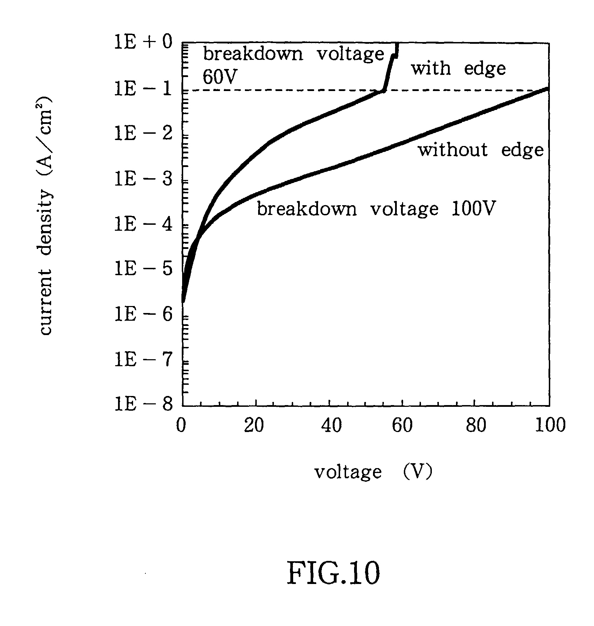

Fig. 10 is a graph showing variations of breakdown voltages of the capacitor elements having dielectric films 14 with and without the edge. When the dielectric film 14 is an STO film and there is an edge therein, the breakdown voltage is lowered to about 60V. However, when there is no edge, the breakdown voltage as high as 100V can be obtained.

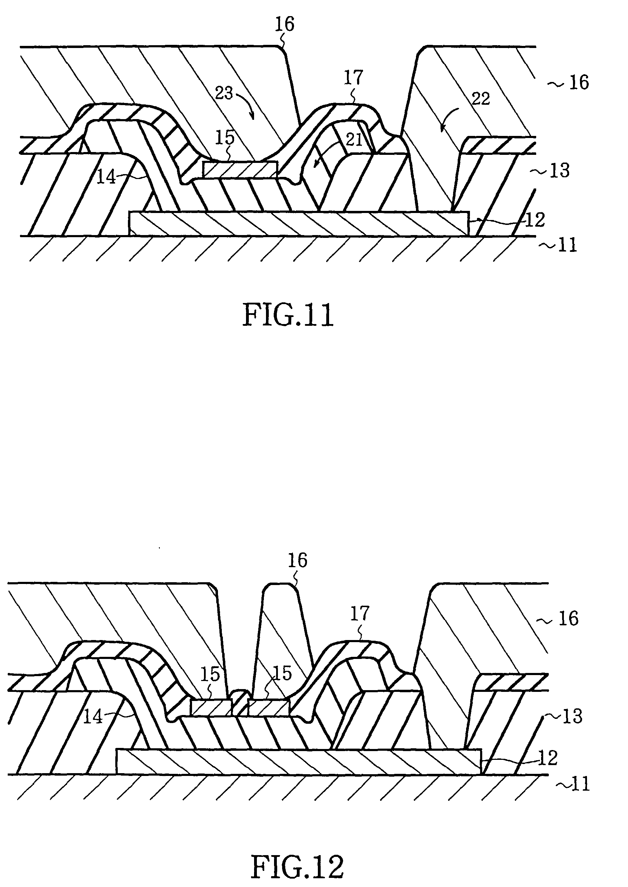

Fig. 11 is a cross section of a capacitor element according to a fourth embodiment of the present invention. In Fig. 11, this capacitor element comprises a lower electrode 12, a dielectric film 14 and an upper electrode 15 formed on a substrate 11 in the order. The capacitor element further comprises a first interlayer insulating film 13 formed to cover the lower electrode 12. The first interlayer insulating film 13 is formed with a first and second through-holes 21 and 22. The dielectric film 14 is formed on the first through-hole 21 and on a portion of the dielectric film 14, which surrounds the first through-hole 21. The upper electrode 15 is formed inside the first through-hole 21, particularly, on the dielectric film 14 outside the edge of the through-hole 21. A second interlayer insulating film 17 is formed to cover the dielectric film 14. Wiring layers 16 are connected to the upper electrode 15 and the lower electrode 12 through a third through-hole 23 provided in the second interlayer insulating film 17 and the second through-hole 22, respectively.

Fig.12 is a cross section of a capacitor element according to a fifth embodiment of the present invention. This capacitor element differs from the fourth embodiment shown in Fig. 11 in that a plurality of upper electrodes 15 are provided. By providing the plurality of the upper electrodes 15 and connecting wiring layers 16 to the upper electrodes by means of regulation electrodes, it is possible to easily increase the capacitance of the capacitor element and to regulate the capacitance.

In Figs. 11 and 12, the inner walls of the first and second through-holes 21 and 22 formed in the first interlayer insulating film 13 are inclined. However, according to the capacitor element shown in either Fig. 11 or Fig. 12, it is possible to obtain a high breakdown voltage compared with that of the conventional capacitor element even when the inner walls thereof are not inclined.

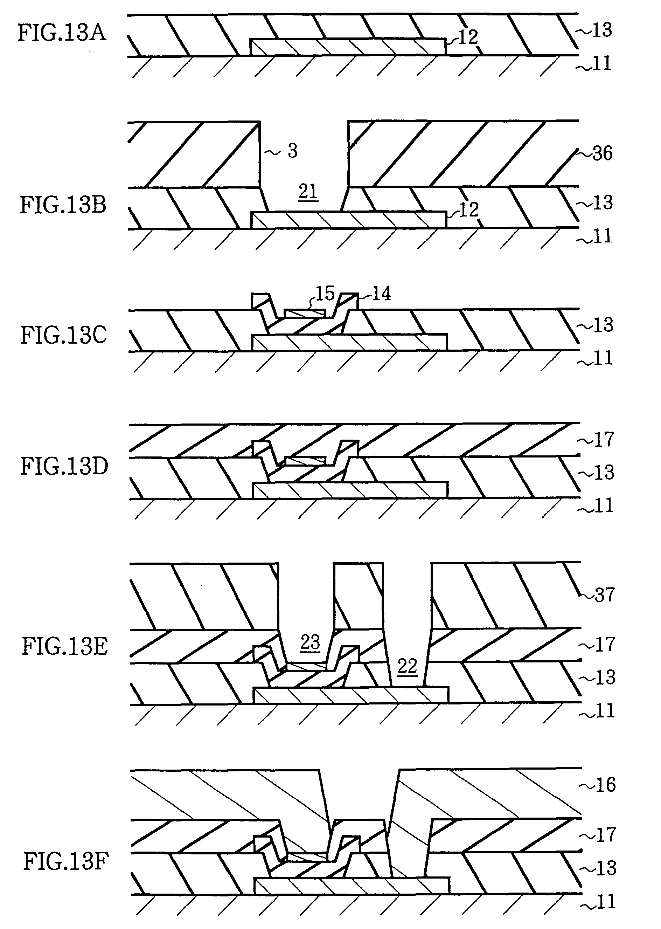

Figs. 13A to 13F show fabrication steps for fabricating the capacitor element shown in Fig. 11. It should be noted that the capacitor element shown in Fig. 12 can be fabricated similarly. First, the lower electrode 12 is formed on the substrate 11 and is covered by the first interlayer insulating film 13, as shown in Fig. 13A. Then, the first through-hole 21 is formed in the first interlayer insulating film 13 by using a photo resist mask 36, as shown in Fig. 13B. Then, as shown in Fig. 13C, the dielectric film 14 is formed on the first through-hole 21 and the periphery thereof and the upper electrode 15 is formed on the dielectric film 14 within the first through-hole 21. In the case of the capacitor element shown in Fig. 12, a plurality of the upper electrodes 15 are formed in this step. Then, as shown in Fig. 13D, the second interlayer insulating film 17 covering the upper electrode 15 is formed and, then, the second through-hole 22 reaching the lower electrode 12 and the third through-hole 23 reaching the upper electrode 15 are formed in the second interlayer insulating film 17 by using a photo resist mask 37, as shown in Fig. 13E. Thereafter, the wiring layers 16 connected to the lower electrode 12 and the upper electrode 15 which are exposed through the second and third through-holes 22 and 23, respectively, are formed as shown in Fig. 13F.

As described hereinbefore, in the capacitor element according to the first aspect of the present invention, in which the upper electrode can be formed simultaneously with a wiring layer of other semiconductor element, it is possible to restrict a reaction between the upper electrode and the dielectric film such as the STO film having high dielectric constant and, particularly, containing titanium, by providing the platinum barrier layer in at least a portion of the upper electrode, which is in contact with the dielectric film. Therefore, it is possible to prevent a degradation of the reliability of the capacitor element after fabricated.

Further, the coverage of the dielectric film is improved by inclining the inner wall of the through-hole formed in the dielectric film. Therefore, the reduction of thickness of the dielectric film at the edge of the step is prevented, so that the leak current can be prevented and a reduction of breakdown voltage can be prevented.

According to the second aspect of the present invention, the dielectric film formed is flat. Therefore, there is no edge portion, so that a reduction of breakdown voltage can be prevented. Further, since, when the crystalline dielectric material having high dielectric constant is used to form the dielectric film, the latter is formed on the flat substrate, the crystallinity thereof is improved and the relative dielectric constant of the dielectric film is increased, resulting in a large capacitance.

According to the third aspect of the present invention, a reduction of breakdown voltage is prevented even with the edge portion in the dielectric film, since the upper electrode is positioned in the area in which the upper electrode does not influence the edge portion. In the case where a plurality of upper electrodes are provided, the capacitance regulation becomes easy and the area occupied by these electrodes can be smaller than that required when a number of capacitor elements for capacitance regulation.

According to the present invention, it is possible to realize the capacitor element having the structure which is easily integrated with other elements, by using a material containing titanium, particularly, SrTiO_{3,} BaTiO_{3,} (BaₓSr₁₋ₓ) TiO_{3,} PbTiO_{3,} (PbZr)TiO₃ or Sr(BiTa)O as the dielectric film material. Since these materials have high dielectric constant, the resultant capacitor element has a large capacitance, so that it becomes possible to form a plurality of capacitor elements at high density.

When the dielectric film is formed on a limited area including the first through-hole and the periphery thereof, it is possible to prevent the reaction between the dielectric film and the substrate from occurring. Particularly, when the dielectric film is formed of a material containing titanium, it is possible to prevent titanium from contaminating the substrate to thereby prevent other elements such as FET's formed on the same substrate from being degraded.

Further, by forming the dielectric film and the upper electrode together, the fabrication step becomes efficient and the forming accuracy of the dielectric film is improved.

## Claims

1. A capacitor element including a lower electrode, a dielectric film and an upper electrode formed on a substrate in the order, said capacitor element comprising:
an interlayer insulating film formed on said lower electrode;
a first and second through-holes formed in said interlayer insulating film;
said dielectric film and said upper electrode being formed in said first through-hole and extending onto said interlayer insulating film;
wiring layers connected to said upper electrode and a portion of said lower electrode, which is exposed through said second through-hole, respectively; and
a barrier layer of platinum provided on at least a portion of said upper electrode, which is in contact with said dielectric film, for restricting a reaction between said upper electrode and said dielectric film.

2. A capacitor element as claimed in claim 1, wherein an inner wall of said first through-hole is inclined with respect to a surface of said substrate by an angle of 75 degree or less.

3. A capacitor element as claimed in claim 1, wherein said dielectric film is formed of a material containing titanium.

4. A capacitor element as claimed in claim 3, wherein said material containing titanium is at least one selected from a group consisting of SrTiO₃, BaTiO₃, (BaₓSr₁₋ₓ)TiO₃, PbTiO₃ and (PbZr)TiO₃.

5. A capacitor element as claimed in claim 1, wherein said dielectric film is formed of Sr(BiTa)O.

6. A capacitor element as claimed in claim 1, wherein said dielectric film is formed on a limited area including said first through-hole and a periphery thereof.

7. A capacitor element including a lower electrode, a dielectric film and an upper electrode formed on a substrate in the order, said capacitor element comprising:
an interlayer insulating film covering said lower electrode and said dielectric film; a first through-hole and a second through-hole formed in said interlayer insulating film, said first through-hole reaching said dielectric film and said second through-hole reaching said lower electrode;
said upper electrode being formed in said first through-hole and extending onto said interlayer insulating film; and
wiring layers connected to said upper electrode and a portion of said lower electrode which is exposed through said second through-hole, respectively.

8. A capacitor element as claimed in claim 7, wherein a platinum barrier layer platinum for restricting a reaction between said upper electrode and said dielectric film is provided in at least a portion of said upper electrode, which is in contact with said dielectric film.

9. A capacitor element as claimed in claim 7, wherein said dielectric film is formed of a material containing titanium.

10. A capacitor element as claimed in claim 9, wherein said material containing titanium is at least one selected from a group consisting of SrTiO₃, BaTiO₃, (Baₓ Sr₁₋ₓ)TiO₃, PbTiO₃ and (PbZr)TiO₃.

11. A capacitor element as claimed in claim 9, wherein said dielectric film is formed of Sr(BiTa)O.

12. A capacitor element as claimed in claim 9, wherein said dielectric film is formed on a limited area including said first through-hole and a periphery thereof.

13. A capacitor element including a lower electrode, a dielectric film and an upper electrode formed on a substrate in the order, said capacitor element comprising:
a first interlayer insulating film covering said lower electrode;
a first through-hole and a second through-hole formed in said first interlayer insulating film;
said dielectric film being provided on said first through-hole and extending onto said first interlayer insulating film surrounding said first through-hole;
said upper electrode being formed on said dielectric film within said first through-hole;
a second interlayer insulating film formed to cover said dielectric film;
a third through-hole formed in said second interlayer insulating film; and
wiring layers connected to said upper electrode and said lower electrode through said third through-hole and said second through-hole, respectively.

14. A capacitor element as claimed in claim 13, wherein a plurality of said upper electrodes are provided for said first through-hole.

15. A capacitor element as claimed in claim 13, wherein a platinum barrier layer platinum for restricting a reaction between said upper electrode and said dielectric film is provided in at least a portion of said upper electrode, which is in contact with said dielectric film.

16. A capacitor element as claimed in claim 7, wherein said dielectric film is formed of a material containing titanium.

17. A capacitor element as claimed in claim 16, wherein said material containing titanium is at least one selected from a group consisting of SrTiO₃, BaTiO₃, (Baₓ Sr₁₋ₓ)TiO₃, PbTiO₃ and (PbZr)TiO₃.

18. A capacitor element as claimed in claim 13, wherein said dielectric film is formed of Sr(BiTa)O.

19. A capacitor element as claimed in claim 13, wherein said dielectric film is formed on a limited area including said first through-hole and a periphery thereof.

20. A method for fabricating a capacitance element, comprising the steps of:
forming a lower electrode on a substrate and covering said lower electrode by an interlayer insulating film;
forming a first through-hole in said interlayer insulating film;
forming a dielectric film and an upper electrode on said first through-hole and a peripheral portion thereof, in the order, and then forming a second through-hole in said interlayer insulating film; and
forming wiring layers connected to said upper electrode and a portion of said lower electrode, which is exposed through the second through-hole, respectively.

21. A method for fabricating a capacitor element, as claimed in claim 20, wherein, after said dielectric film and said upper electrode are formed, portions of said capacitor element, which are unnecessary for said capacitor element are removed.

22. A method for fabricating a capacitor element, comprising the steps of:
forming a lower electrode and a dielectric film on a substrate, in the order, and hole reaching said lower electrode in said interlayer insulating film;
forming an upper electrode on said first through-hole and a peripheral portion thereof; and
wiring layers connected to said upper electrode and a portion of said lower electrode, which is exposed through said second through-hole, respectively.

23. A method for fabricating a capacitor element, comprising the steps of:
forming a lower electrode on a substrate and covering said lower electrode by a first interlayer insulating film;
forming a first through-hole in said first interlayer insulating film;
forming a dielectric film on said first through-hole and a peripheral portion thereof;
forming an upper electrode on said dielectric film within said first through-hole;
forming a second interlayer insulating film covering said upper electrode;
forming a second through-hole reaching said lower electrode and a third through-hole reaching said upper electrode in said second interlayer insulating film; and
forming wiring layers connected to said lower electrode exposed through said second through-hole and said upper electrode exposed through said third through-hole, respectively.
